# EUROPÄISCHE PATENTSCHRIFT

(11) **EP 1 022 810 B1**
(45) Veröffentlichungstag und Bekanntmachung des Hinweises auf die Patenterteilung: **19.12.2007**
(21) Anmeldenummer: 00100774.9
(22) Anmeldetag: 15.01.2000
(51) Int. Cl.: H01R 12/04, H01R 4/02, H01R 43/02

(54) **Verfahren zum Verbinden eines Kabels mit einer Leiterplatte und Geh-use mit einem nach dem Verfahren mit der Leiterplatte verbundenen Kabel**
Method for connecting a cable with a printed circuit board and housing with cable connected to the circuit board according to the method
Méthode de connexion d'un câble sur une plaque à circuits imprimés et bôitier avec câble connecté sur une plaque à circuits imprimés suivant cette méthode

(30) Priorität: 22.01.1999 DE 19902428
(43) Veröffentlichungstag der Anmeldung: 26.07.2000
(73) Patentinhaber: Siemens VDO Automotive AG, 93055 Regensburg (DE)
(72) Erfinder: Ullrich, Horst, 61137 Schöneck (DE)

(56) Entgegenhaltungen:
- EP-A- 0 148 037
- DE-A- 1 690 380
- DE-A- 3 412 815
- DE-C- 19 712 842
- US-A- 4 494 308

## Beschreibung

Die Erfindung betrifft ein Verfahren zum Verbinden eines in eine Kabelaufnahme eines Gehäuses einzusetzenden Kabels nach dem Oberbegriff des Anspruchs 1. Weiterhin betrifft die Erfindung ein Gehäuse zum Halten einer Leiterplatte nach dem Oberbegriff des Anspruchs 2.

Kabel werden derzeit dadurch mit einer Leiterplatte verbunden, dass man zunächst das Kabelende mit einem Lötstift verbindet, welcher mit einem Leiter die Leiterplatte durchdringt und auf der Oberseite der Leiterplatte mit ihr verlötet wird. Diese Kabel mit dem Lötstift führt man vor dem Spritzgießen des Gehäuses in die Spritzgießform ein, so dass beim Herstellen des Gehäuses der Lötstift mit dem Kabel umspritzt wird.

Aus der DE 19 712 842 C ist ein Verfahren zum Verbinden eines in eine Kabelaufnahme eines Gehäuses einzusetzenden Kabels mit einer von dem Gehäuse getragenen Leiterplatte mittels eines sich quer zur Haupterstreckungsrichtung des Kabels von der Kabelaufnahme durch die Leiterplatte führenden Leiters bekannt, wobei der Leiter durch Umbiegen eines Endbereiches des Kabels quer zur Haupterstreckungsrichtung des Kabels erzeugt wird.

Diese Art der Verbindung eines Kabels mit einer Leiterplatte erfordert einen Lötstift als das Kabel mit der Leiterplatte verbindendes Bauteil. Da das Kabel mit dem Lötstift in einer Spritzgießform positioniert werden muss, ist der Aufwand zur Erstellung der elektrischen Verbindung zwischen dem Kabel und der Leiterplatte relativ groß.

Der Erfindung liegt das Problem zugrunde, ein Verfahren der eingangs genannten Art so zu gestalten, dass mit möglichst geringem Aufwand ein Gehäuse mit einem eine Leiterplatte verbindenden Kabel versehen werden kann. Weiterhin soll ein zur Durchführung dieses Verfahrens besonders geeignetes Gehäuse mit einem solchen Kabel geschaffen werden.

Das erstgenannte Problem wird erfindungsgemäß dadurch gelöst, dass das Umbiegen der Kabelader durch Einschieben des Kabels quer zu seiner Haupterstreckung in eine zur Seite der Leiterplatte hin offene Kabelaufnahme erfolgt.

Durch eine solche Verfahrensweise spart man ein Bauteil ein, nämlich den in das Gehäuse einzuspritzenden Lötstift. Dieser Lötstift wird durch die Umbiegung des Endbereiches der Kabelader erzeugt. Dieses Umbiegen des Endbereiches der Kabelader erfordert wesentlich geringeren Aufwand als das Anlöten des Lötstiftes an die Kabelader, so dass insgesamt nicht nur die Kosten durch Einsparung eines Bauteils herabgesetzt werden, sondern auch noch der Herstellungsaufwand sich verringert.

Die erforderliche Umbiegung der Kabelader kann bei der Montage des Kabels zwangsläufig erfolgen, so dass kein zusätzlicher Arbeitsgang erforderlich wird, wenn gemäß einer Weiterbildung des Verfahrens das Umbiegen der Kabelader durch Einschieben des Kabels quer zu seiner Haupterstreckung in eine zur Seite der Leiterplatte hin offene Kabelaufnahme erfolgt.

Das zweitgenannte Problem, nämlich die Schaffung eines mit einem Kabel versehenen Gehäuses zum Halten einer Leiterplatte, wird erfindungsgemäß durch die kennzeichnenden Merkmale des Anspruchs 2 gelöst. Mit einem solchen Gehäuse lässt sich ein Bauteil mit einer Leiterplatte sehr kostengünstig herstellen, weil das Kabel für das Bauteil auf besonders einfache Weise montiert und mit der Leiterplatte verbunden werden kann.

Zugkräfte am Kabel führen nicht dazu, dass das Kabel aus der Kabelaufnahme herausgelangt und die Verbindung zwischen der Kabelader und der Leiterplatte zerstört wird, wenn die Kabelaufnahme an zumindest einer Seite eine ihren Querschnitt einengende Rippe hat, durch die der verbleibende Querschnitt geringer ist, als es dem Außendurchmesser des Kabels entspricht und die in einem Abstand zur Grundfläche der Kabelaufnahme endet, der größer als der Radius des Kabels, jedoch kleiner als sein Durchmesser ist. Da die Rippe nicht bis zum Grund der Kabelaufnahme reicht, verhindert sie zugleich, dass das Kabel zur Seite der Leiterplatte hin aus der Kabelaufnahme gelangen kann.

Das Kabel wird besonders gut in der Kabelaufnahme gehalten, wenn gemäß einer anderen Weiterbildung der Erfindung an beiden gegenüberliegenden Seiten der Kabelaufnahme Rippen vorgesehen sind.

Das Kabel wird sehr fest in der Kabelaufnahme gehalten, ohne dass sein Hineinschieben unerwünscht große Kräfte erfordert, wenn insgesamt an jeder Seite drei Rippen vorgesehen sind.

Die Rippen drücken sich in die Isolation des Kabels ein und halten das Kabel durch einen Formschluss, wenn die Rippen im Querschnitt die Form eines Dreiecks haben, dessen Spitze zum Kabel hin gerichtet ist.

Die Erfindung lässt verschiedene Ausführungsformen zu. Zur weiteren Verdeutlichung ihres Grundprinzips ist eine davon in der Zeichnung dargestellt und wird nachfolgend beschrieben. Diese zeigt in
- Fig.1: einen Schnitt durch ein Gehäuse mit einem Kabel vor dem Einsetzen in eine Kabelaufnahme des Gehäuses,
- Fig.2: die Anordnung nach Figur 1 nach dem Einsetzen des Kabels,
- Fig.3: die Anordnung nach den Figuren 1 und 2 nach der Montage der Leiterplatte,
- Fig.4: eine Draufsicht auf die Anordnung nach Fig.2.

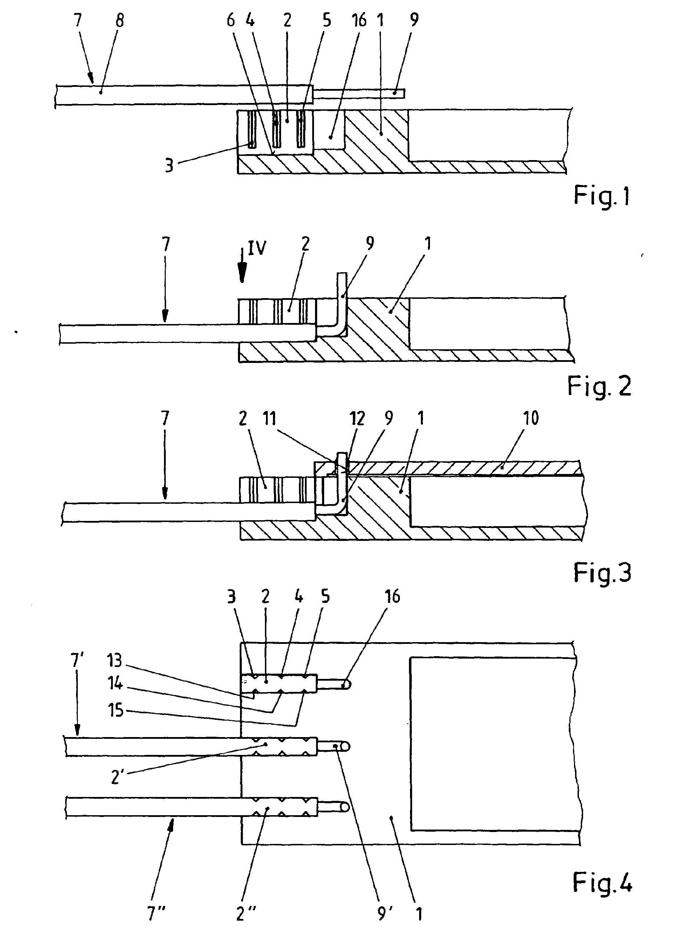

Die Figur 1 zeigt ein Gehäuse 1 mit einer als nach oben hin offene Gehäuseausnehmung gestalteten Kabelaufnahme 2, deren Querschnitt durch Rippen 3, 4, 5 eingeengt ist. Diese Rippen 3, 4, 5 führen von oben her in die Kabelaufnahme 2 hinein und enden mit geringem Abstand zu einer Grundfläche 6 der Kabelaufnahme 2.

Oberhalb des Gehäuses 1 ist in der Figur 1 ein Kabel 7 dargestellt, welches eine als verzinnte Kupferlitze ausgeführte Kabelader 9 und eine Isolation 8 hat. Ein vorderer Bereich der Kabelader 9 wurde von der Isolation 8 befreit und erstreckt sich in Figur 1 in Haupterstreckungsrichtung des Kabels 8 über die Kabelaufnahme 2 hinaus bis über das Gehäuse 1.

Drückt man das Kabel 7 quer zu seiner Haupterstreckungsrichtung in die Kabelaufnahme 2 hinein dann gelangt das vordere Ende der Kabelader 9 gegen das Gehäuse 1 und wird um 90° abgebogen, um es dem Kabel 7 zu ermöglichen, vollständig in die Kabelaufnahme 2 zu gelangen, was die Figur 2 zeigt. Ihr ist zu entnehmen, dass das vordere Ende der Kabelader 9 nach oben hin wie ein Stift aus der Kabelaufnahme 2 herausragt.

In der in Figur 3 gezeigten Fertigungsstufe wurde eine Leiterplatte 10 derart auf das Gehäuse 1 gesetzt, dass das Ende der Kabelader 9 durch eine Bohrung 11 der Leiterplatte 10 ragt. Die elektrische Verbindung zwischen der Leiterplatte 10 und der Kabelader 9 wurde durch eine Lötstelle 12 erzeugt.

Der Figur 4 ist zu entnehmen, dass die Kabelaufnahmen 2 jeweils an ihren gegenüberliegenden Seiten einander gegenüberliegend drei Rippen 3, 4, 5 und 13, 14, 15 haben und dass diese dreieckigen Querschnitt aufweisen, wobei die jeweilige Spitze in die Kabelaufnahme 2 ragt. Weiterhin sieht man in Figur 4, dass die Kabelaufnahme 2 jeweils einen Fortsatz 16 geringerer Breite hat, die geringfügig größer ist als der Durchmesser der Kabelader 9. Das Gehäuse 1 gemäß Figur 4 hat insgesamt drei Kabelaufnahmen 2, 2' und 2", wobei in den Kabelaufnahmen 2' und 2" jeweils ein Kabel 7' und 7" eingezeichnet wurde.

## Patentansprüche

1. Verfahren zum Verbinden eines in eine Kabelaufnahme (2) eines Gehäuses (1) einzusetzenden Kabels (7) mit einer von dem Gehäuse getragenen Leiterplatte (10) mittels eines sich quer zur Haupterstreckungsrichtung des Kabels von der Kabelaufnahme durch die Leiterplatte führenden Leiters, welcher auf der Oberseite der Leiterplatte (10) mit dieser verlötet ist, wobei der Leiter durch Umbiegen eines Endbereiches der Kabelader (9) quer zur Haupterstreckungsrichtung des Kabels (7) erzeugt wird,
**dadurch gekennzeichnet, dass** das Umbiegen der Kabelader (9) durch Einschieben des Kabels (7) quer zu seiner Haupterstreckung in eine zur Seite der Leiterplatte (10) hin offene Kabelaufnahme (2) erfolgt.

2. Gehäuse (1) zum Halten einer Leiterplatte (10), welches mit einer Kabelaufnahme (2) versehen ist, in der ein eine Kabelader (9) aufweisendes Kabel (7) einsetzbar ist und das mittls eines Leiters mit der Leiterplatte Verbindbar ist, wobei die Kabelaufnahme (2) von der Seite der Leiterplatte (10) her in das Gehäuse (1) hineinführt **dadurch gekennzeichnet, dass** der zur Leiterplatte (10) führende Leiter durch eine Umbiegung des vorderen Endes der Kabelader (9) durch Einschieben des kabels (7) quer zu seiner Haupterstreckung in der Kabelaufnahme (2) gebildet werden kann, und dass die Kabelaufnahme (2) an zumindest einer Seite eine ihren Querschnitt einengende Rippe (3, 4, 5) hat, durch die der verbleibende Querschnitt geringer ist, als es dem Außendurchmesser des Kabels (7) entspricht und die in einem Abstand zur Grundfläche (6) der Kabelaufnahme (2) endet, der größer als der Radius des Kabels (7), jedoch kleiner als sein Durchmesser ist.

3. Gehäuse nach Anspruch 2, **dadurch gekennzeichnet, dass** an beiden gegenüberliegenden Seiten der Kabelaufnahme (2) Rippen (3, 4, 5; 13, 14, 15) vorgesehen sind.

4. Gehäuse nach Anspruch 2, **dadurch** gekennzeichne t, dass insgesamt an jeder Seite drei Rippen (3, 4, 5; 13, 14, 15) vorgesehen sind.

5. Gehäuse nach zumindest einem der vorangehenden Ansprüche, **dadurch gekennzeichnet, dass** die Rippen (3, 4, 5; 13, 14, 15) im Querschnitt die Form eines Dreiecks haben, dessen Spitze zum Kabel (7) hin gerichtet ist.

## Claims

1. Method for connecting a cable (7), which is to be inserted into a cable receptacle (2) of a housing (1), to a printed circuit board (10) supported by the housing by means of a conductor which is led transverse to the direction of the main extent of the cable from the cable receptacle through the printed circuit board and is soldered to the printed circuit board (10) on the top side thereof, in which the conductor is produced by bending over an end region of the cable strand (9) transverse to the direction of the main extent of the cable (7), **characterized in that** the cable strand (9) is bent over by pushing the cable (7) transverse to its main extent into a cable receptacle (2) which is open toward the side of the printed circuit board (10).

2. Housing (1) for holding a printed circuit board (10), which is provided with a cable receptacle (2) in which a cable (7) having a cable strand (9) is insertable, and which is connectable to the printed circuit board by means of a conductor, in which the cable receptacle (2) is guided into the housing (1) starting from the side of the printed circuit board (10), **characterized in that** the conductor leading to the printed circuit board (10) can be formed by bending over the front end of the cable strand (9) by pushing the cable (7) transverse to its main extent into the cable receptacle (2), and **in that** the cable receptacle (2) has on at least one side a rib (3, 4, 5) which constricts its cross section and owing to which the remaining cross section is smaller than corresponds to the outside diameter of the cable (7), and which ends at a spacing from the base surface (6) of the cable receptacle (2) which is greater than the radius of the cable (7) but smaller than its diameter.

3. Housing according to claim 2, **characterized in that** ribs (3, 4, 5; 13, 14, 15) are provided on both opposite sides of the cable receptacle (2).

4. Housing according to claim 2, **characterized in that** a total of three ribs (3, 4, 5; 13, 14, 15) are provided on each side.

5. Housing according to at least one of the preceding claims, **characterized in that** the ribs (3, 4, 5; 13, 14, 15) have a cross section in the shape of a triangle whose vertex is directed toward the cable (7).

## Revendications

1. Procédé permettant de connecter un câble (7) à mettre en place dans un logement (2) de câbles d'un boîtier (1) avec une carte à circuits imprimés (10) portée par le boîtier, au moyen d'un conducteur traversant, à partir du logement de câbles, la carte à circuits imprimés perpendiculairement à la direction de l'extension principale du câble, ledit conducteur étant soudé, sur la face supérieure de la carte à circuits imprimés (10), à cette dernière, ledit conducteur étant produit par cintrage d'une extrémité du fil (9) du câble perpendiculairement à la direction de l'extension principale du câble (7),
**caractérisé par le fait que** le cintrage du fil (9) du câble est obtenu en introduisant le câble (7), perpendiculairement à son extension principale, dans un logement (2) de câbles ouvert sur le côté de la carte à circuits imprimés (10).

2. Boîtier (1) destiné à maintenir une carte à circuits imprimés (10) et doté d'un logement (2) de câbles dans lequel peut être inséré un câble (7) comportant un fil (9) et pouvant être connecté, au moyen d'un conducteur, à la carte à circuits imprimés, le logement (2) de câbles conduisant, à partir du côté de la carte à circuits imprimés (10), dans le boîtier (1), **caractérisé par le fait que** le conducteur conduisant à la carte à circuits imprimés (10) peut être formé grâce à un cintrage de l'extrémité avant du fil (9) du câble en introduisant le câble (7), perpendiculairement à son extension principale, dans le logement (2) de câbles et que le logement (2) de câbles a, sur au moins un côté, une nervure (3, 4, 5) réduisant sa section transversale grâce à laquelle la section transversale restante est plus petite que celle correspondant au diamètre extérieur du câble (7) et qui se termine à une distance de la surface de fond (6) du logement (2) de câbles supérieure au rayon du câble (7), mais inférieure à son diamètre.

3. Boîtier selon la revendication 2, **caractérisé par le fait qu'**il est prévu des nervures (3, 4, 5; 13, 14, 15) sur les deux côtés se faisant face du logement (2) de câbles.

4. Boîtier selon la revendication 2, **caractérisé par le fait qu'**il est prévu au total, sur chaque côté, trois nervures (3, 4, 5; 13, 14, 15).

5. Boîtier selon au moins l'une des revendications précédentes, **caractérisé par le fait que** les nervures (3, 4, 5; 13, 14, 15) ont en section transversale la forme d'un triangle dont la pointe est dirigée vers le câble (7).
